# EUROPEAN PATENT APPLICATION

(11) **EP 3 933 505 A1**
(43) Date of publication of application: **05.01.2022**
(21) Application number: 20762676.3
(22) Date of filing: 29.01.2020
(51) Int. Cl.: G03F 7/004, G02B 5/20, C09B 67/20

(54) **CYAN-COLORED CURABLE COMPOSITION**

(30) Priority: 28.02.2019 JP 2019036723
(71) Applicant: SUMITOMO CHEMICAL COMPANY LIMITED, Chuo-ku Tokyo 104-8260 (JP)
(72) Inventor: NAKAYAMA, Tomohiro, Osaka-shi, Osaka 554-8558 (JP)
(74) Representative: Vossius & Partner Patentanwälte Rechtsanwälte mbB
(86) International application number: PCT/JP2020/003253
(87) International publication number: WO 2020/174991

(57) **Abstract**

An object of the present invention is to provide a cyan colored curable composition useful for producing a color filter and other products having high sensitivity and color separability. A cyan colored curable composition comprising a colorant, a resin, a polymerizable compound, and a polymerization initiator, the colorant comprising a compound represented by formula (1) and an organic pigment: 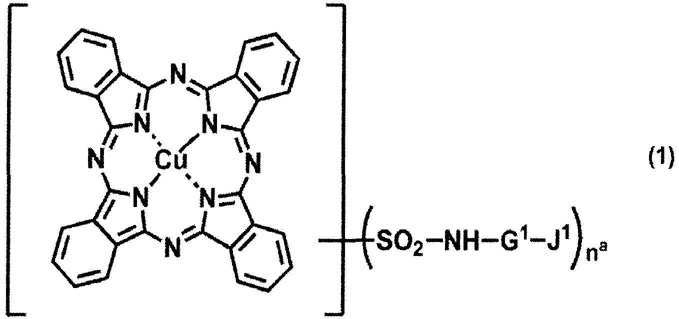 wherein G¹ represents a C₂₋₂₀ alkanediyl group, wherein -CH₂- contained in the alkanediyl group is optionally substituted with -O-, J¹ represents a hydrogen atom, -NR^{a}R^{b}, or -NR^{a}R^{b}H⁺Q⁻, R^{a} and R^{b} each independently represent a hydrogen atom or a C₁₋₈ alkyl group, Q⁻ represents a halide ion, BF₄⁻, PF₆⁻, ClO₄⁻, X-CO₂⁻, or X-SO₃⁻, X represents a monovalent organic group, and n^{a} represents an integer of 1 to 4.

## Description

### TECHNICAL FIELD

The present invention relates to a colored curable composition. In detail, the present invention relates to a cyan colored curable composition.

### BACKGROUND ART

A color filter used for display devices such as a liquid crystal display device, an electroluminescence display device, and a plasma display, and solid-state image sensors such as a CCD and a CMOS sensor is produced from a colored curable resin composition. As a colored curable resin composition for forming such a color filter, a cyan colored curable resin composition has been demanded. Patent Document 1 discloses, as a composition for forming a color filter, a colored photosensitive composition in which the colorant contains a phthalocyanine-based dye and further a xanthene-based dye. However, such a colored photosensitive composition is not a cyan composition but a blue composition. Patent Document 2 discloses, as a cyan colored curable resin composition for a color filter, a cyan heat-curable resin composition containing C.I. Pigment Green 58 and a blue pigment as colorants.

### PRIOR ART DOCUMENTS

### PATENT DOCUMENTS

Patent Document 1: Japanese Patent Laid-Open No. 2011-28236
Patent Document 2: Japanese Patent Laid-Open No. 2010-26107

### SUMMARY OF THE INVENTION

### PROBLEMS TO BE SOLVED BY THE INVENTION

However, color filters formed from the cyan colored curable resin composition for a color filter disclosed in Patent Document 2 have not been sufficiently satisfactory in terms of sensitivity and color separability.

An object of the present invention is to provide a cyan colored curable composition useful for producing a color filter and other products having high sensitivity and color separability.

### SOLUTIONS TO THE PROBLEMS

The gist of the present invention is as follows.
[1] A cyan colored curable composition comprising a colorant, a resin, a polymerizable compound, and a polymerization initiator,
   the colorant comprising a compound represented by formula (1) and an organic pigment: 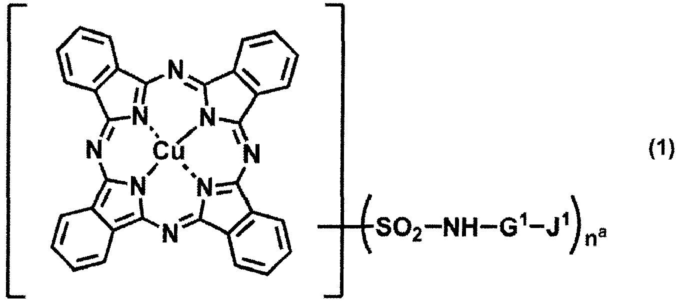 wherein
   G¹ represents a C₂₋₂₀ alkanediyl group, wherein -CH₂- contained in the alkanediyl group is optionally substituted with -O-,
   J¹ represents a hydrogen atom, -NR^{a}R^{b}, or -NR^{a}R^{b}H⁺Q⁻,
   R^{a} and R^{b} each independently represent a hydrogen atom or a C₁₋₈ alkyl group, and when formula (1) has a plurality of R^{a}s, the R^{a}s may be the same or different from each other, and when formula (1) has a plurality of R^{b}s, the R^{b}s may be the same or different from each other,
   Q⁻ represents a halide ion, BF₄⁻, PF₆⁻, ClO₄⁻, X-CO₂⁻, or X-SO₃⁻,
   X represents a monovalent organic group,
   in a case where formula (1) has a plurality of Q⁻s, the Q⁻s may be the same or different from each other, and
   n^{a} represents an integer of 1 to 4.
[2] The cyan colored curable composition according to [1], wherein the organic pigment is a blue organic pigment.
[3] The cyan colored curable composition according to [1] or [2], wherein the organic pigment is a phthalocyanine pigment.
[4] The cyan colored curable composition according to any one of [1] to [3], wherein the organic pigment is at least one selected from the group consisting of C.I. Pigment Blue 15, C.I. Pigment Blue 15:3, C.I. Pigment Blue 15:4, and C.I. Pigment Blue 15:6.
[5] The cyan colored curable composition according to any one of [1] to [4], further comprising a solvent.
[6] A color filter formed from the cyan colored curable composition according to any one of [1] to [5].
[7] A solid-state image sensor comprising the color filter according to [6].

### EFFECT OF THE INVENTION

According to the present invention, a cyan colored curable composition useful for producing a color filter and other products having high sensitivity and color separability can be provided.

### DESCRIPTION OF EMBODIMENTS

A cyan colored curable composition of the present invention contains a colorant (hereinafter, sometimes referred to as colorant (A)), a resin (hereinafter, sometimes referred to as resin (B)), a polymerizable compound (hereinafter, sometimes referred to as polymerizable compound (C)), and a polymerization initiator (hereinafter, sometimes referred to as polymerization initiator (D)).

The colorant (A) contains a compound represented by formula (1) (hereinafter, sometimes referred to as compound (1)) and an organic pigment (hereinafter, sometimes referred to as organic pigment (Al)).

The colorant (A) may contain a colorant (hereinafter, sometimes referred to as colorant (A2)) other than compound (1) and organic pigment (A1).

The cyan colored curable composition of the present invention is preferable to further contain a solvent (hereinafter, sometimes referred to as solvent (E)).

The cyan colored curable composition of the present invention may further contain a polymerization initiation aid (hereinafter, sometimes referred to as polymerization initiation aid (D1)).

The cyan colored curable composition of the present invention may further contain a leveling agent (hereinafter, sometimes referred to as leveling agent (F)).

Herein, compounds exemplified as components may be used singly or in combinations with a plurality thereof unless otherwise noted.

### <Colorant (A)>

The colorant (A) contains a compound (1) and an organic pigment (A1).

### <Compound (1)>

The compound (1) is a compound represented by the following formula (1): 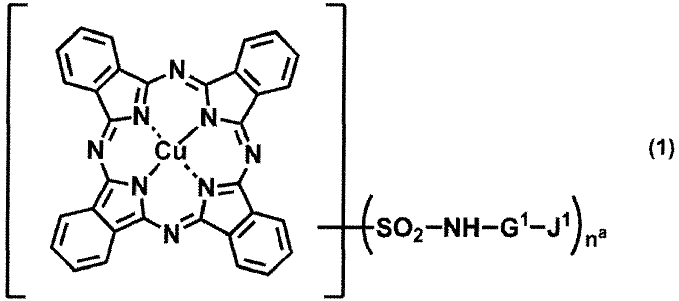 wherein
G¹ represents a C₂₋₂₀ alkanediyl group, wherein -CH₂- contained in the alkanediyl group is optionally substituted with -O-,
J¹ represents a hydrogen atom, -NR^{a}R^{b}, or -NR^{a}R^{b}H⁺Q⁻,
R^{a} and R^{b} each independently represent a hydrogen atom or a C₁₋₈ alkyl group, and when formula (1) has a plurality of R^{a}s, the R^{a}s may be the same or different from each other, and when formula (1) has a plurality of R^{b}s, the R^{b}s may be the same or different from each other,
Q⁻ represents a halide ion, BF₄⁻, PF₆⁻, ClO₄⁻, X-CO₂⁻, or X-SO₃⁻,
X represents a monovalent organic group,
in a case where formula (1) has a plurality of Q⁻s, the Q⁻s may be the same or different from each other, and
n^{a} represents an integer of 1 to 4.

The compound (1) represents a compound in which n^{a} hydrogen atoms contained in a compound represented by the following formula (1-0) are each substituted with -SO₂-NH-G¹-J¹. In the case where n^{a} is an integer of 2 or more, the plurality of SO₂-NH-G¹-J¹s may be the same or different from each other. 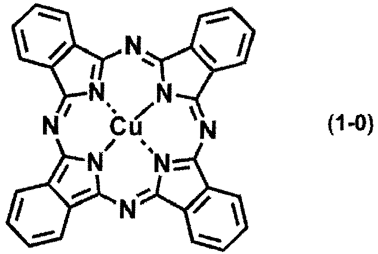 n^{a} is preferably an integer of 2 or more, and more preferably an integer of 3 or more.

Examples of the C₂₋₂₀ alkanediyl group represented by G¹ include: straight alkanediyl groups such as a methylene group, an ethylene group, a propane-1,3-diyl group, a butane-1,4-diyl group, a pentane-1,5-diyl group, and a hexane-1,6-diyl group; and branched alkanediyl groups such as a 1-methylethane-1,2-diyl group, a 1-methylpropane-1,3-diyl group, a 2-methylpropane-1,3-diyl group, a 1-methylbutane-1,4-diyl group, a 2-ethylbutane-1,4-diyl group, a 1,3-dimethylbutane-1,4-diyl group, a 1,1,3,3-tetramethylbutane-1,4-diyl group, a 2-methylpentane-1,5-diyl group, a 4-methylpentane-1,5-diyl group, a 1,4-dimethylpentane-1,5-diyl group, a 2-methylhexane-1,6-diyl group, a 2-ethylhexane-1,6-diyl group, a 5-methylhexane-1,6-diyl group, a 1,5-dimethylhexane-1,6-diyl group, a 2-ethylheptane-1,7-diyl group, and a 6-ethylheptane-1,7-diyl group. The number of carbon atoms in the alkanediyl group represented by G¹ is preferably 2 to 15, more preferably 2 to 10, and, in the case of a straight alkanediyl group, still more preferably 2 to 5, while in the case of a branched alkanediyl group, still more preferably 5 to 10.

As the alkanediyl group represented by G¹, in the case of a straight alkanediyl group, apropane-1,3-diyl group is particularly preferable, while in the case of a branched alkanediyl group, a 5-methylhexane-1,6-diyl group is particularly preferable.

In the case where -CH₂- contained in the C₂₋₂₀ alkanediyl group represented by G¹ is substituted with -O-, examples of such groups include groups represented by the following formula (G-1) and groups represented by the following formula (G-2).

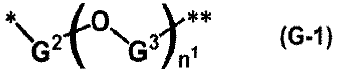

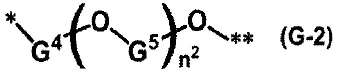

[In formula (G-1) and formula (G-2), G² to G⁵ each independently represent a C₁₋₁₀ alkanediyl group.
n¹ represents an integer of 1 to 3.
n² represents an integer of 0 to 3.

Note that the total number of carbon atoms and oxygen atoms contained in a group represented by formula (G-1) is 3 to 20, and the total number of carbon atoms and oxygen atoms contained in a group represented by formula (G-2) is 2 to 20.
* represents a bond with -NH-, and ** represents a bond with J¹.]

Examples of the C₁₋₁₀ alkanediyl group represented by G² to G⁵ include: straight alkanediyl groups such as a methylene group, an ethylene group, a propane-1,3-diyl group, a butane-1,4-diyl group, a pentane-1,5-diyl group, and a hexane-1,6-diyl group; and branched alkanediyl groups such as a 1-methylethane-1,2-diyl group, a 1-methylpropane-1,3-diyl group, a 2-methylpropane-1,3-diyl group, a 1-methylbutane-1,4-diyl group, a 2-ethylbutane-1,4-diyl group, a 2-methylpentane-1,5-diyl group, a 4-methylpentane-1,5-diyl group, a 2-methylhexane-1,6-diyl group, a 5-methylhexane-1,6-diyl group, a 2-ethylheptane-1,7-diyl group, and a 6-ethylheptane-1,7-diyl group. The number of carbon atoms in the alkanediyl group represented by G² to G⁵ is preferably 1 to 8, more preferably 1 to 5.

In the case where the C₂₋₂₀ alkanediyl group represented by G¹ is a branched alkanediyl group, a group in which -CH₂- contained in the alkanediyl group is substituted with -O- is preferable, a group represented by formula (G-1) is more preferable, and a group in which n¹ in the group represented by formula (G-1) is 1 is still more preferable.

Examples of the C₁₋₈ alkyl group represented by R^{a} and R^{b} include a methyl group, an ethyl group, a propyl group, and a butyl group.

As the C₁₋₈ alkyl group represented by R^{a} and R^{b}, a C₁₋₅ alkyl group is preferable, a C₁₋₃ alkyl group is more preferable, and a methyl group is still more preferable.

Examples of the monovalent organic group represented by X include a C₁₋₂₀ alkyl group, a C₃₋₂₀ cycloalkyl group, a C₆₋₂₀ aryl group, and a combination thereof.

Examples of the C₁₋₂₀ alkyl group include a methyl group, an ethyl group, a propyl group, a butyl group, a hexyl group, and a decyl group. Examples of the C₃₋₂₀ cycloalkyl group include a cyclopropyl group, a cyclobutyl group, a cyclopentyl group, a cyclohexyl group, and a cyclodecyl group. Examples of the C₆₋₂₀ aryl group include a phenyl group, a naphthyl group, and an anthryl group.

X-CO₂⁻ represented by Q⁻ is an organic anion containing a CO₂⁻ group, and X-SO₃⁻ represented by Q⁻ is an organic anion containing a SO₃⁻ group. For example, as the organic anions, anions represented by the following formula (Q-1) to formula (Q-4) can be mentioned.

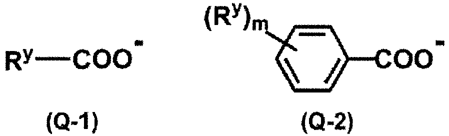

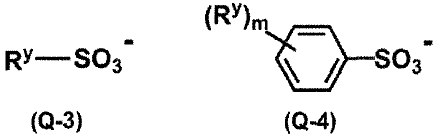

[In formula (Q-1) to formula (Q-4), R^{y} represents a C₁₋₂₀ alkyl group.
m represents an integer of 0 to 5.]

Examples of the C₁₋₂₀ alkyl group represented by R^{y} include a methyl group, an ethyl group, a propyl group, a butyl group, a hexyl group, a decyl group, and a dodecyl group.

As J¹, in the case where the alkanediyl group represented by G¹ is a straightalkanediyl group, -NR^{a}R^{b} is preferable, while in the case where the alkanediyl group represented by G¹ is a branched alkanediyl group, a hydrogen atom is preferable.

As -SO₂-NH-G¹-J¹, for example, groups represented by the following formulae can be mentioned.

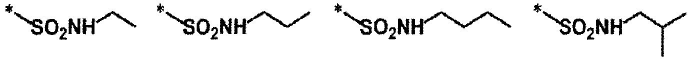

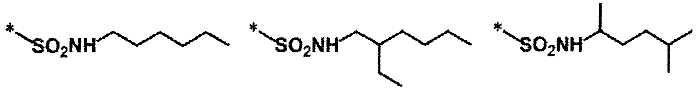

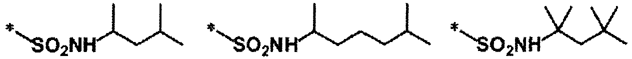

[In the formulae, * represents a bond with a compound represented by formula (1-0).]

In the case where G¹ is a group represented by formula (G-1), as -SO₂-NH-G¹-J¹, for example, groups represented by the following formulae can be mentioned.

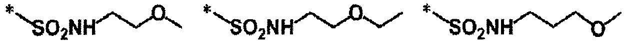

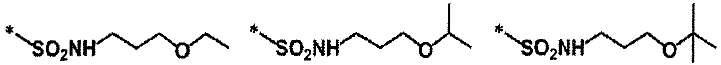

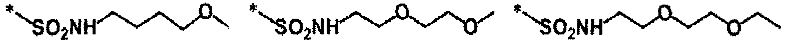

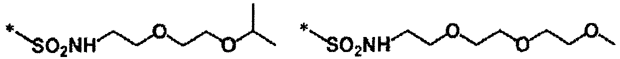

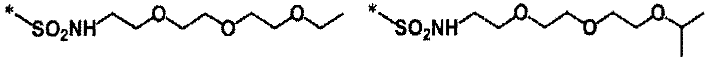

[In the formulae, * represents a bond with a compound represented by formula (1-0).]

In the case where G¹ is a group represented by formula (G-2), as -SO₂-NH-G¹-J¹, for example, groups represented by the following formulae can be mentioned.

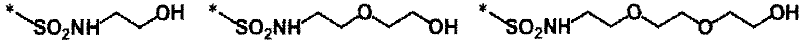

[In the formulae, * represents a bond with a compound represented by formula (1-0).]

In the case where J¹ is -NR^{a}R^{b}, as -SO₂-NH-G¹⁻J¹, for example, groups represented by the following formulae can be mentioned.

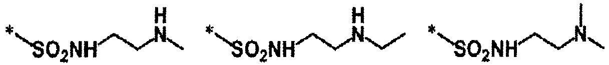

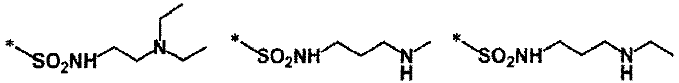

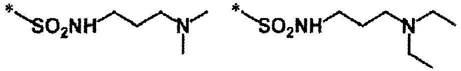

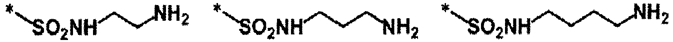

[In the formulae, * represents a bond with a compound represented by formula (1-0).]

In the case where J¹ is -NR^{a}R^{b}H⁺Q⁻, as -SO₂-NH-G¹-NR^{a}R^{b}H⁺, for example, groups represented by the following formulae can be mentioned.

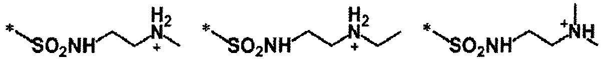

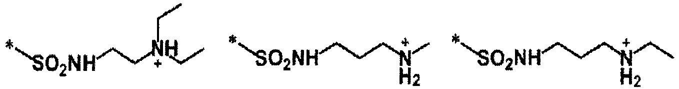

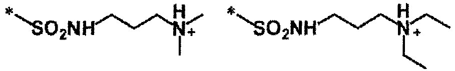

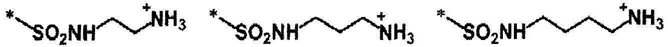

[In the formulae, * represents a bond with a compound represented by formula (1-0).]

Examples of the compound (1) include compounds represented by formula (1-1) to formula (1-92). Of the compounds represented by formula (1-1) to formula (1-92), in the case where n^{a} is an integer of 2 or more, it is preferable that the plurality of -SO₂-NH-G¹-J¹s are respectively attached to different benzene rings.

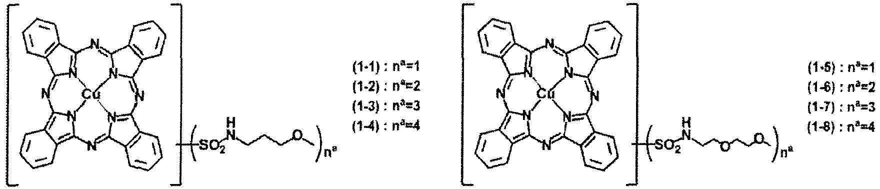

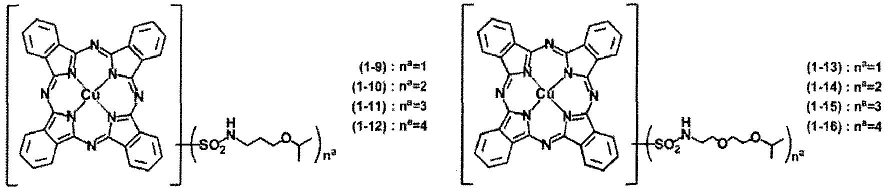

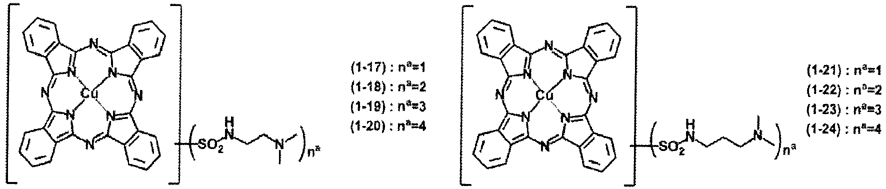

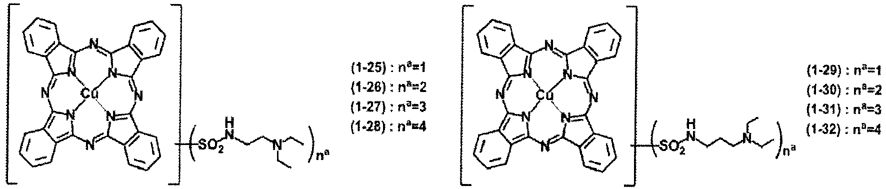

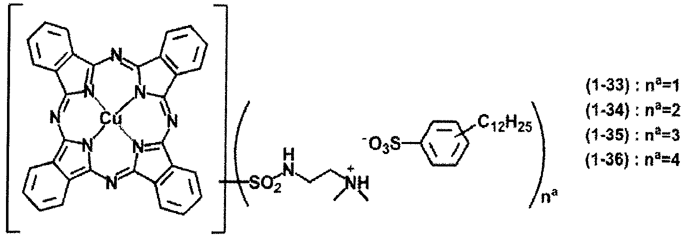

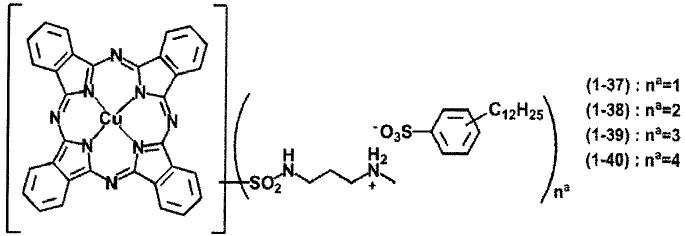

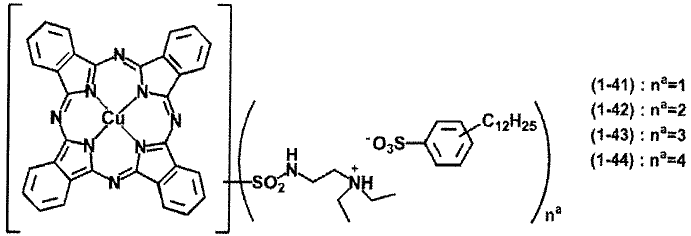

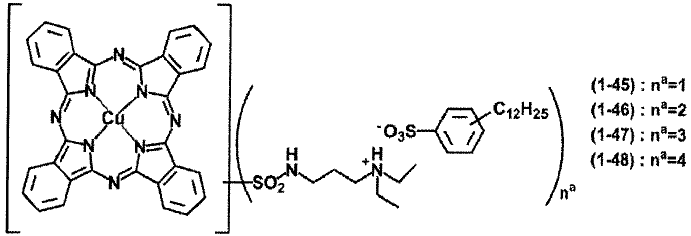

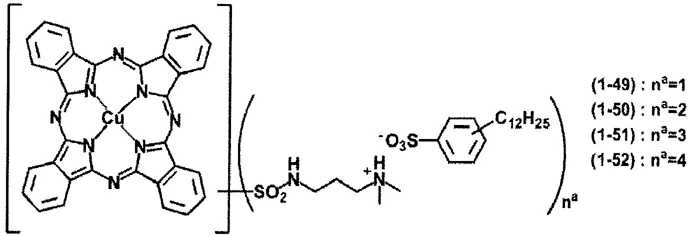

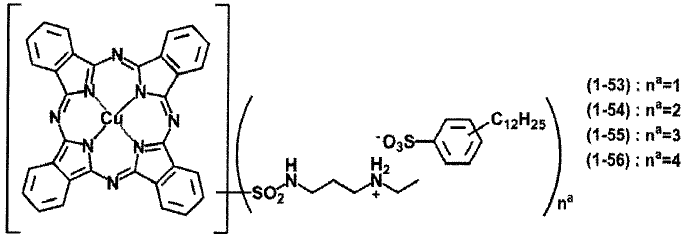

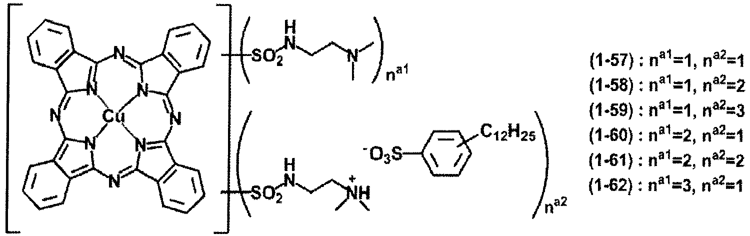

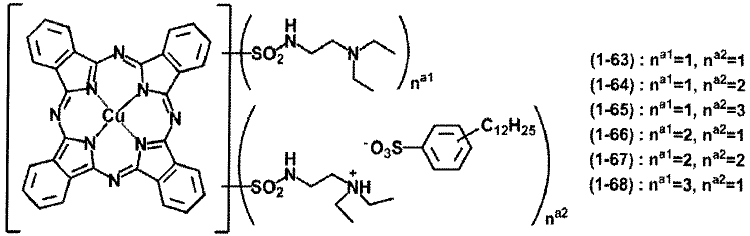

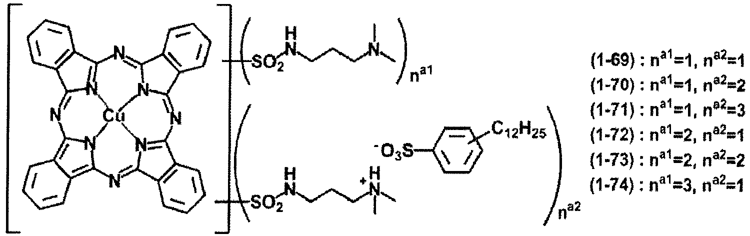

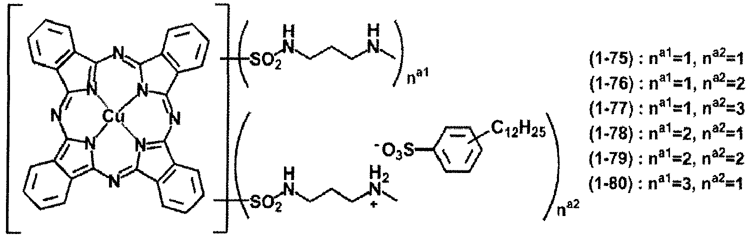

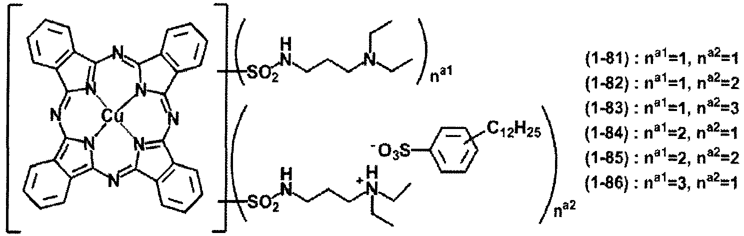

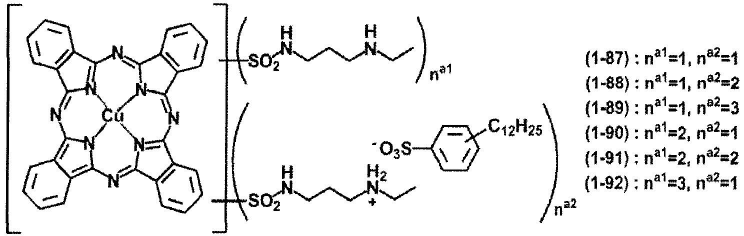

More specific examples of compounds represented by formula (1-11) include, for example, compounds represented by the following formula (1-11-1) and formula (1-11-2). More specific examples of compounds represented by (1-24) include, for example, compounds represented by the following formula (1-24-1) and formula (1-24-2).

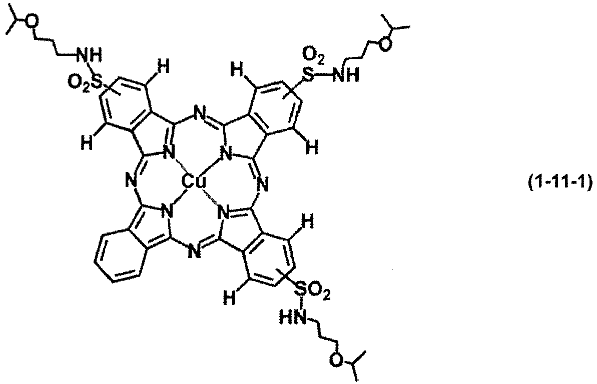

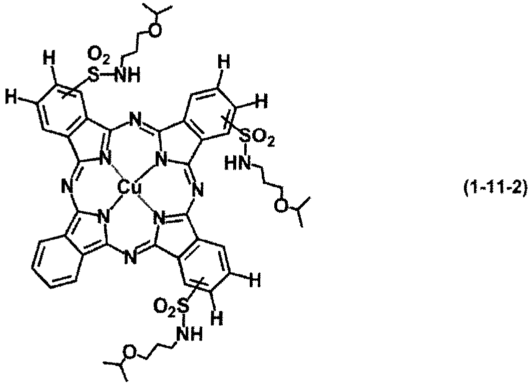

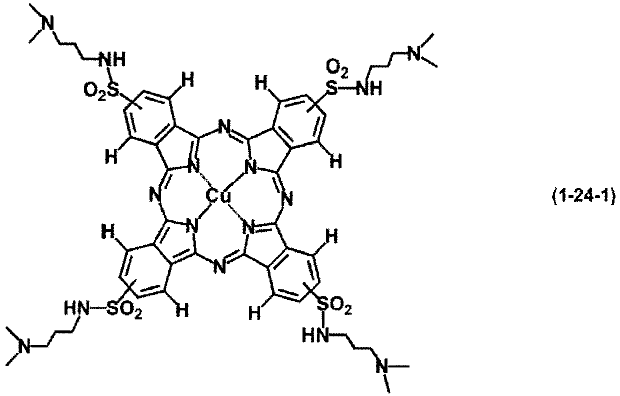

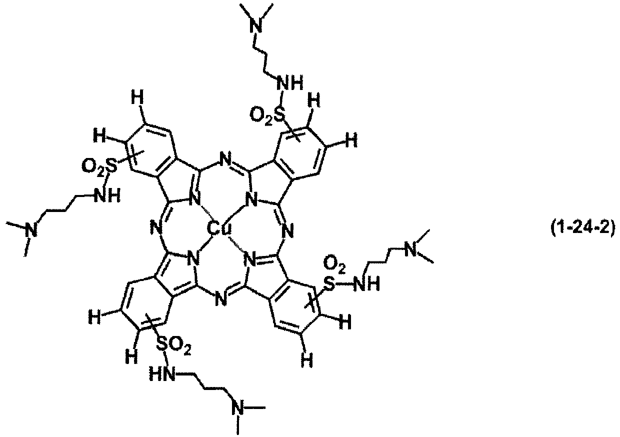

Among them, as the compound (1),
compounds represented by formula (1-1) to formula (1-32) are preferable,
a compound represented by formula (1-3), formula (1-7), formula (1-11), formula (1-15), formula (1-20), formula (1-24), formula (1-28), or formula (1-32) is more preferable,
a compound represented by formula (1-11), formula (1-15), formula (1-20), or formula (1-24) is still more preferable,
a compound represented by formula (1-11) or formula (1-24) is yet more preferable, and
a compound represented by formula (1-11-1), formula (1-11-2), formula (1-24-1), or formula (1-24-2) is particularly preferable.

A method for producing the compound (1) is not particularly limited, and production with reference to the synthesis examples described in Japanese Patent Laid-Open No. 2011-28236 is also possible.

The content of the compound (1) is, relative to 100 parts by mass of the resin (B), preferably 1 to 150 parts by mass, more preferably 5 to 140 parts by mass, still more preferably 10 to 120 parts by mass, and yet more preferably 15 to 100 parts by mass.

In terms of providing a cyan colored curable composition with excellent cyan color characteristics and also achieving high sensitivity and high color separability, the content of the compound (1) is, in the total amount of the colorant (A), preferably 5 mass% or more to less than 100 mass%, more preferably 10 to 99 mass%, still more preferably 20 to 97 mass%, and particularly preferably 30 to 95 mass%. The content of the compound (1) in the total amount of the colorant (A) is yet more preferably 90 mass% or less, and particularly preferably 85 mass% or less. In addition, the content of the compound (1) in the total amount of the colorant (A) is yet more preferably 50 mass% or more, and particularly preferably 60 mass% or more.

### << Organic Pigment (A1)>>

Known organic pigments can be used as the organic pigment (Al) without particular limitation. Examples thereof include an organic pigment which is classified into a pigment in the Color Index (published by The Society of Dyers and Colourists).

Examples of the organic pigment (Al) include: yellow organic pigments such as C.I. Pigment Yellows 1, 3, 12, 13, 14, 15, 16, 17, 20, 24, 31, 53, 83, 86, 93, 94, 109, 110, 117, 125, 128, 137, 138, 139, 147, 148, 150, 153, 154, 166, 173, 194 and 214; orange organic pigments such as C.I. Pigment Oranges 13, 31, 36, 38, 40, 42, 43, 51, 55, 59, 61, 64, 65, 71 and 73;
red organic pigments such as C.I. Pigment Reds 9, 97, 105, 122, 123, 144, 149, 166,
168, 176, 177, 180, 192, 202, 209, 215, 216, 224, 242, 254, 255, 264, 265, 269 and 291;
blue organic pigments such as C.I. Pigment Blues 15, 15:3, 15:4, 15:6, 16 and 60;
violet organic pigments such as C.I. Pigment Violets 1, 19, 23, 29, 32, 36 and 38;
green organic pigments such as C.I. Pigment Greens 7, 36, 58, 59 and 63;
brown organic pigments such as C.I. Pigment Browns 23 and 25; and
black organic pigments such as C.I. Pigment Blacks 1 and 7.

As the organic pigment (Al), a blue organic pigment such as C.I. Pigment Blue 15, 15:3, 15:4, 15:6, or 16 is preferably contained.

As the organic pigment (Al), a phthalocyanine pigment is preferably contained, and a copper phthalocyanine pigment is more preferably contained.

In particular, as the organic pigment (Al), in terms of providing a cyan colored curable composition with excellent cyan color characteristics and also achieving high sensitivity and high color separability, at least one selected from the group consisting of C.I. Pigment Blue 15, C.I. Pigment Blue 15:3, C.I. Pigment Blue 15:4, and C.I. Pigment Blue 15:6 is preferably contained.

As the organic pigment (Al), the known organic pigments described above may be used alone, and it is also possible to use a combination of two or more kinds. The content of the blue organic pigment is, in the total amount of the organic pigment (Al), preferably 70 to 100 mass%, more preferably 80 mass% or more, still more preferably 85 mass% or more, and particularly preferably 90 mass% or more.

The organic pigment(Al) preferably has a uniform particle diameter. A pigment dispersant is added, followed by performing a dispersion treatment, whereby a pigment dispersion in which the pigment is uniformly dispersed in a solution can be produced.

As the pigment dispersant, for example, surfactants can be mentioned, and such surfactants may be cationic, anionic, nonionic, or amphoteric. Specifically, polyester-based, polyamine-based, and acrylic-based dispersants can be mentioned, for example. These dispersants may be used alone, and it is also possible to use a combination of two or more kinds. Example of the dispersant include KP (product name) (manufactured by Shin-Etsu Chemical Co., Ltd.), Flowlen (manufactured by Kyoeisha Chemical Co., Ltd.), Solsperse (registered trademark) (manufactured by Zeneca), EFKA (registered trademark) (manufactured by BASF), AJISPER (registered trademark) (manufactured by Ajinomoto Fine-Techno Co., Inc.), and Disperbyk (registered trademark) (manufactured by BYK-Chemie). The below-described resin (B) may also be used as a dispersant.

When the pigment dispersant is used, the content of the pigment dispersant is, relative to 100 parts by mass of the organic pigment(Al), preferably 1 to 100 parts by mass, more preferably 5 to 75 parts by mass. When the content of the pigment dispersant falls within the above range, there is a tendency that the pigment dispersion having a uniform dispersion state is obtained.

In the case where two or more kinds of organic pigments (Al) are used, each may be prepared as a dispersion and mixed at the time of use.

The content of the organic pigment (A1) is, relative to 100 parts by mass of the resin (B), preferably 0.05 to 100 parts by mass, more preferably 0.1 to 80 parts by mass, still more preferably 1 to 70 parts by mass, and yet more preferably 2 to 60 parts by mass.

In terms of providing a cyan colored curable composition with excellent cyan color characteristics and also achieving high sensitivity and high color separability, the content of the organic pigment (Al) is, in the total amount of the colorant (A), preferably 1 to 95 mass%, more preferably 1 to 90 mass%, still more preferably 3 to 80 mass%, and yet more preferably 5 to 70 mass%. The content of the organic pigment (Al) in the total amount of the colorant (A) is even more preferably 50 mass% or less, and particularly preferably 40 mass% or less. The content of the organic pigment (Al) in the total amount of the colorant (A) is even more preferably 10 mass% or more, and particularly preferably 15 mass% or more.

### <<Colorant (A2)>>

The cyan colored curable composition of the present invention may contain, as a colorant (A2), a dye (hereinafter sometimes referred to as dye (A2-1)) and/or a pigment (hereinafter, sometimes referred to as pigment (A2-2)) other than the compound (1) and the organic pigment (A1).

As the dye (A2-1), known dyes can be used without particular limitations as long as the compound (1) is not included. For example, solvent dyes, acidic dyes, direct dyes, mordant dyes, and the like can be mentioned. Examples of the dye include a compound which is not a pigment but classified into a compound having a hue in the Color Index (published by The Society of Dyers and Colourists), and a known dye as described in Dying note (Shikisensha Co., Ltd.). According to chemical structures, the dye include an azo dye, a cyanine dye, a triphenylmethane dye, a xanthene dye, a phthalocyanine dye (except for compound (1)), an anthraquinone dye, a naphthoquinone dye, a quinonimine dye, a methine dye, an azomethine dye, a squarylium dye, an acridine dye, a styryl dye, a coumarin dye, and a nitro dye. Among these, a dye which is soluble in an organic solvent is preferable. However, xanthene dyes are preferred not to be used because they may prevent the achievement of cyan color characteristics.

Examples of the pigment (A2-2) include inorganic pigments of metal compounds such as metal oxides and metal complex salts. Specifically, oxides or composite metal oxides of metals such as iron, cobalt, aluminum, cadmium, lead, copper, titanium, magnesium, chromium, zinc, and antimony can be mentioned.

In terms of providing a cyan colored curable composition with excellent cyan color characteristics, the content of the dye (A2-1) and/or the pigment (A2-2) is, in the total amount of the colorant (A), preferably 30 mass% or less, more preferably 20 mass% or less, and still more preferably 10 mass% or less. It is particularly preferable that the colorant (A) contains substantially no dye (A2-1) and/or pigment (A2-2) .

The content of the colorant (A) is, based on the total solids content of the cyan colored curable composition, preferably 0.1 to 60 mass%, more preferably 0.5 to 55 mass%, and still more preferably 5 to 55 mass%. When the content of the colorant (A) is within the above range, the color density of the resulting color filter is sufficient, and also the required amount of resin (B) can be contained in the composition, allowing for the formation of a pattern with sufficient mechanical strength; therefore, this is preferable.

The term "total solids content" as used herein means an amount obtained by excluding the content of the solvent from the whole amount of the cyan colored curable composition. The total solids content and the content of each of the components with respect thereto can be measured by known analysis means such as liquid chromatography or gas chromatography.

### <Resin (B)>

The resin (B) is not particularly limited, but is preferably an alkali-soluble resin, and more preferably a resin having a structural unit derived from at least one member (a) selected from the group consisting of unsaturated carboxylic acids and unsaturated carboxylic anhydrides (hereinafter sometimes referred to as "(a)"). The resin (B) preferably further has at least one structural unit selected from the group consisting of a structural unit derived from a monomer (b) having a C₂₋₄ cyclic ether structure and an ethylenically unsaturated bond (hereinafter sometimes referred to as "(b)"), a structural unit derived from a monomer (c) copolymerizable with (a) (and different from (a) and (b)) (hereinafter sometimes referred to as "(c)"), and a structural unit having an ethylenically unsaturated bond in the side chain.

Examples of (a) include acrylic acid, methacrylic acid, maleic anhydride, itaconic anhydride, 3,4,5,6-tetrahydrophthalic anhydride, and mono[2-(meth)acryloyloxyethyl] succinate. As (a), acrylic acid, methacrylic acid, and maleic anhydride are preferable.

(b) is preferably a monomer having a C₂₋₄ cyclic ether structure (e.g., at least one member selected from the group consisting of an oxirane ring, an oxetane ring, and a tetrahydrofuran ring) and a (meth)acryloyloxy group.

Incidentally, as used herein, "(meta)acrylic acid" expresses at least one member selected from the group consisting of acrylic acid and methacrylic acid. Expressions such as "(meth)acryloyl" and "(meth)acrylate" also have the same meaning.

Examples of (b) include glycidyl (meth)acrylate, vinylbenzyl glycidyl ether, 3,4-epoxytricyclo[5.2.1.0^{2,6}]decyl (meth)acrylate, 3-ethyl-3-(meth)acryloyloxymethyl oxetane, and tetrahydrofurfuryl (meth)acrylate. As (b), glycidyl (meth)acrylate, 3,4-epoxytricyclo[5.2.1.0^{2,6}]decyl (meth)acrylate, and 3-ethyl-3-(meth)acryloyloxymethyl oxetane are preferable.

Examples of (c) include methyl (meth)acrylate, butyl (meth)acrylate, cyclohexyl (meth)acrylate, 2-methylcyclohexyl (meth)acrylate, tricyclo[5.2.1.0^{2,6}]decan-8-yl (meth)acrylate, benzyl (meth)acrylate, 2-hydroxyethyl (meth)acrylate, N-phenyl maleimide, N-cyclohexyl maleimide, N-benzyl maleimide, styrene, and vinyltoluene. As (c), styrene, vinyltoluene, N-phenyl maleimide, N-cyclohexyl maleimide, N-benzyl maleimide, and the like are preferable.

The resin having a structural unit having an ethylenically unsaturated bond in the side chain can be produced by adding (b) to a copolymer of (a) and (c) or adding (a) to a copolymer of (b) and (c). The resin may also be a resin obtained by adding (a) to a copolymer of (b) and (c) and further allowing a carboxylic anhydride to react therewith.

The weight average molecular weight of the resin (B) in terms of polystyrene content is preferably 3,000 to 100,000, more preferably 5,000 to 50,000, and still more preferably 5,000 to 30,000.

The degree of dispersion [weight average molecular weight (Mw)/number average molecular weight (Mn)] of the resin (B) is preferably 1.1 to 6, and more preferably 1.2 to 4.

The acid value of the resin (B) is preferably 50 to 170 mg-KOH/g, more preferably 60 to 150 mg-KOH/g, and still more preferably 70 to 135 mg-KOH/g, in terms of solid content. The acid value as used herein is a value which is measured as an amount (mg) of potassium hydroxide required for neutralizing 1 g of the resin (B), and which can be determined by, for example, titration with an aqueous potassium hydroxide solution.

The content of the resin (B) is, based on the total solids content of the cyan colored curable composition, preferably 25 to 55 mass%, more preferably 30 to 50 mass%, and still more preferably 35 to 45 mass%.

### <Polymerizable Compound (C)>

The polymerizable compound (C) is a compound capable of being polymerized by the action of an active radical and/or an acid generated from the polymerization initiator (D). Examples of the polymerizable compound (C) include a compound having a polymerizable ethylenically unsaturated bond, and is preferably a (meth)acrylic acid ester compound.

Among these, the polymerizable compound (C) is preferably a polymerizable compound having three or more ethylenically unsaturated bonds. Examples of the polymerizable compound include trimethylolpropane tri(meth)acrylate, pentaerythritol tri(meth)acrylate, pentaerythritol tetra(meth)acrylate, dipentaerythritol penta(meth)acrylate, and dipentaerythritol hexa(meth)acrylate.

The weight average molecular weight of the polymerizable compound (C) is preferably 150 or more and 2,900 or less, and more preferably 250 or more and 1,500 or less.

The content of the polymerizable compound (C) is preferably 5 to 45 mass%, more preferably 10 to 40 mass%, and still more preferably 15 to 35 mass%, relative to the total solids content of the cyan colored curable composition.

### <Polymerization Initiator (D)>

The polymerization initiator (D) is not particularly limited, as long as the polymerization initiator (D) is a compound capable of generating active radicals, an acid or the like by the action of light or heat to initiate polymerization. Any known polymerization initiator can be used. Examples of polymerization initiators that generate active radicals include N-benzoyloxy-1-(4-phenylsulfanylphenyl)butan-1-one-2-imine, N-benzoyloxy-1-(4-phenylsulfanylphenyl)octan-1-one-2-imine, N-benzoyloxy-1-(4-phenylsulfanylphenyl)-3-cyclopentylpropan-1-one-2-imine, N-acetyloxy-1-(4-phenylsulfanylphenyl)-3-cyclohexylpropan-1-one-2-imine, 2-methyl-2-morpholino-1-(4-methylsulfanylphenyl)propan-1-one, 2-dimethylamino-1-(4-morpholinophenyl)-2-benzylbutan-1-one, 1-hydroxycyclohexylphenylketone, 2,4-bis(trichloromethyl)-6-piperonyl-1,3,5-triazine, 2,4,6-trimethylbenzoyldiphenylphosphine oxide, and 2,2'-bis(2-chlorophenyl)-4,4',5,5'-tetraphenylbiimidazole.

The content of the polymerization initiator (D) is preferably 0.1 to 30 parts by mass, and more preferably 1 to 20 parts by mass, relative to 100 parts by mass of the whole amount of the resin (B) and the polymerizable compound (C). When the content of the polymerization initiator (D) falls within the above range, there is a tendency that the sensitivity is increased and that the time of exposure to light is shortened, resulting in the improvement in productivity of the color filter.

### <Polymerization Initiation Aid (D1)>

The polymerization initiation aid (D1) is a compound to be used for accelerating polymerization of a polymerizable compound the polymerization of which has been started by the polymerization initiator or is a sensitizer. In the case where the polymerization initiation aid (D1) is contained, the polymerization initiation aid (D1) is commonly used in combination with the polymerization initiator (D).

Examples of the polymerization initiator (D1) include 4,4'-bis(dimethylamino)benzophenone (commonly known as Michler's ketone), 4,4'-bis(diethylamino)benzophenone, 9,10-dimethoxyanthracene, 2,4-diethylthioxanthone, and N-phenylglycine.

In the case where the polymerization initiation aid (D1) is used, the content of the polymerization initiation aid (D1) is preferably 0.1 to 30 parts by mass, and more preferably 1 to 20 parts by mass, relative to 100 parts by mass of the whole amount of the resin (B) and the polymerizable compound (C). When the content of the polymerization initiation aid (D1) falls within the above range, there is a tendency that the colored pattern can be formed with higher sensitivity, resulting in the improvement in productivity of the color filter.

### <Solvent (E)>

The solvent (E) is not particularly limited, and any solvent which has been used conventionally in the art can be used. Examples of the solvent (E) include an ester solvent (a solvent containing -COO- and not containing -O- in the molecule), an ether solvent (a solvent containing -O- and not containing -COO- in the molecule), an ether ester solvent (a solvent containing -COO- and -O- in the molecule), a ketone solvent (a solvent containing -CO- and not containing -COO- in the molecule), an alcohol solvent (a solvent containing OH and not containing -O-, -CO-, and -COO- in the molecule), an aromatic hydrocarbon solvent, an amide solvent, and dimethyl sulfoxide.

Examples of solvents include: ester solvents such as ethyl lactate, butyl lactate, methyl 2-hydroxyisobutate, n-butyl acetate, ethyl butyrate, butyl butyrate, ethyl pyruvate, methyl acetoacetate, cyclohexanol acetate, and y-butyrolactone (solvents containing -COO- and not containing -O- in the molecule);
ether solvents such as ethylene glycol monobutyl ether, diethylene glycol monomethyl ether, propylene glycol monomethyl ether, 3-methoxy-1-butanol, diethylene glycol dimethyl ether, and diethylene glycol methyl ethyl ether (solvents containing -O- and not containing -COO- in the molecule);
ether ester solvents such as methyl 3-methoxypropionate, ethyl 3-ethoxypropionate, 3-methoxybutyl acetate, propylene glycol monomethyl ether acetate, ethylene glycol monoethyl ether acetate, and diethylene glycol monoethyl ether acetate (solvents containing -COO- and -O- in the molecule);
ketone solvents such as 4-hydroxy-4-methyl-2-pentanone (hereinafter sometimes referred to as diacetone alcohol), heptanone, 4-methyl-2-pentanone, and cyclohexanone (solvents containing -CO- and not containing -COO- in the molecule);
alcohol solvents such as butanol, cyclohexanol, and propylene glycol (solvents containing OH and not containing -O-, -CO-, and -COO- in the molecule); and
amide solvents such as N,N-dimethylformamide, N,N-dimethylacetamide, and N-methylpyrrolidone.

As solvents, propylene glycol monomethyl ether acetate, propylene glycol monomethyl ether, ethyl lactate, diacetone alcohol, cyclohexanone, and ethyl 3-ethoxypropionate are more preferable.

In the case where the solvent (E) is contained, the content of the solvent (E) is, based on the total amount of the cyan colored curable composition of the present invention, preferably 70 to 95 mass%, and more preferably 75 to 92 mass%. In other words, the total solids content of the cyan colored curable composition is preferably 5 to 30 mass%, and more preferably 8 to 25 mass%. When the content of solvent (E) falls within the above range, the flatness during application is excellent. Also the color density is not insufficient in the formation of a color filter, which tends to result in excellent display characteristics.

### <Leveling Agent (F)>

Examples of the leveling agent (F) include a silicone-based surfactant, a fluorine-based surfactant, and a silicone-based surfactant having a fluorine atom. These may have a polymerizable group at its side chain.

Examples of the silicone-based surfactant include a surfactant having a siloxane bond in the molecule. Specific examples thereof include Toray Silicone DC3PA, Toray Silicone SH7PA, Toray Silicone DC11PA, Toray Silicone SH21PA, Toray Silicone SH28PA, Toray Silicone SH29PA, Toray Silicone SH30PA, and Toray Silicone SH8400 (product name; manufactured by Dow Corning Toray Co., Ltd.); KP321, KP322, KP323, KP324, KP326, KP340, and KP341 (manufactured by Shin-Etsu Silicone Co., Ltd.); and TSF400, TSF401, TSF410, TSF4300, TSF4440, TSF4445, TSF-4446, TSF4452, and TSF4460 (manufactured by Momentive Performance Materials Inc.).

Examples of the fluorine-based surfactant include a surfactant having a fluorocarbon chain in the molecule. Specific examples thereof include Fluorad (registered trademark) FC430 and Fluorad FC431 (manufactured by Sumitomo 3M, Ltd.); Megafac (registered trademark) F142D, Megafac F171, Megafac F172, Megafac F173, Megafac F177, Megafac F183, Megafac F554, Megafac R30, and Megafac RS-718-K (manufactured by DIC Corporation); Eftop (registered trademark) EF301, Eftop EF303, Eftop EF351, and Eftop EF352 (manufactured by Mitsubishi Materials Electronic Chemicals Co., Ltd.); Surflon (registered trademark) S381, Surflon S382, Surflon SC101, and Surflon SC105 (manufactured by Asahi Glass Co., Ltd.); and E5844 (manufactured by Daikin Finechemical Laboratory).

Examples of the silicone-based surfactant having a fluorine atom include a surfactant having a siloxane bond and a fluorocarbon chain in the molecule. Specific examples thereof include Megafac (registered trademark) R08, Megafac BL20, Megafac F475, Megafac F477, and Megafac F443 (manufactured by DIC Corporation).

In the case where the leveling agent (F) is contained, the content of the leveling agent (F) is, based on the total amount of the cyan colored curable composition, preferably 0.001 to 0.2 mass%, and more preferably 0.002 to 0.1 mass%. The content of the leveling agent (F) does not include the content of the pigment dispersant. When the content of the leveling agent (F) falls within the above range, the flatness of the color filter can be improved.

### <Other Components>

The cyan colored curable composition of the present invention may contain additives known in the art, such as a filler, other polymeric compound, an adhesion promoter, an antioxidant, a light stabilizer, a chain transfer agent, etc., as needed.

### <Method for Producing Cyan Colored Curable Composition>

The cyan colored curable composition of the present invention can be prepared by mixing a colorant (A), a resin (B), a polymerizable compound (C), and a polymerization initiator (D), and a solvent (E), a leveling agent (F), and other component used if necessary.

It is preferable that the organic pigment (Al) and a pigment that serves as the pigment (A2-2) used if necessary are previously mixed with part or all of the solvent (E) and dispersed using a bead mill or the like until the average particle size of the pigments reaches about 0.2 µm or less. At this time, the pigment dispersant and/or part or all of the resin (B) may also be blended if necessary. With the pigment dispersion thus obtained, the remaining components are mixed to a predetermined concentration, whereby a cyan colored curable composition can be prepared.

### <Method for Producing Color Filter>

Examples of the method for producing the colored pattern from the cyan colored curable composition of the present invention include a photolithography method, an inkjet method, and a printing method. Among these methods, a photolithography method is preferable. The photolithography method is a method in which the cyan colored curable composition is applied onto a substrate and then dried to form a coloring composition layer, and the coloring composition layer is then developed by exposing the coloring composition layer to light through a photomask. In the photolithography method, the photomask is not used during the exposure to light, and/or the coloring composition layer is not developed, whereby a colored coating film which is a hardened material of the coloring composition layer can be formed. The colored pattern and the colored coating film which have been formed thus are the color filter of the present invention.

Examples of the substrate to be used include: glass substrates such as quartz glass, borosilicate glass, alumina silicate glass, and soda lime glass of which the surface is coated with silica; resin substrates such as polycarbonate, poly(methyl methacrylate), and polyethylene terephthalate; silicon; and substrates on which aluminum, silver, or a silver/copper/palladium alloy thin film or the like is formed. On these substrates, other color filter layer, a resin layer, a transistor, a circuit and the like may be formed.

The formation of each color pixel using a photolithography method can be carried out using a known or conventional device or under known or conventional conditions. For example, the color pixel can be prepared in the following manner. First, a colored composition is applied onto a substrate, and then dried by heat-drying (prebaking) and/or drying under reduced pressure to remove volatile components such as a solvent from the composition, thereby producing a smooth coloring composition layer.

Examples of the application method include a spin coat method, a slit coat method, and a slit-and-spin coat method.

The temperature to be employed when heat-drying is carried out is preferably 30 to 120°C, and more preferably 50 to 110°C. The time for the heating is preferably 10 seconds to 5 minutes, and more preferably 30 seconds to 3 minutes.

When drying under reduced pressure is carried out, the drying procedure is preferably carried out at a temperature range of 20 to 25°C under a pressure of 50 to 150 Pa.

The film thickness of the coloring composition layer is not particularly limited, and may be selected appropriately depending on the desired film thickness of the color filter.

Next, the coloring composition layer is exposed to light through a photomask for forming a desired colored pattern. The pattern on the photomask is not particularly limited, and a pattern suitable for the intended application is used.

A light source to be used for the exposure to light is preferably a light source capable of generating light having a wavelength of 250 to 450 nm. For example, light having a wavelength of shorter than 350 nm may be cut with a filter capable of cutting light having this wavelength region, or light having a wavelength of around 436 nm, around 408 nm, or around 365 nm may be extracted selectively with a band-pass filter capable of extracting light having those wavelength region. Specific examples thereof include a mercury lamp, a light-emitting diode, a metal halide lamp, and a halogen lamp.

A light-exposing device such as a mask aligner and a stepper is preferably used because the device is capable of emitting a parallel light beam uniformly over the whole area of the exposed surface or accurately aligning the photomask to the substrate which has the coloring composition layer formed thereon.

A colored pattern is formed on the substrate by bringing the exposed coloring composition layer into contact with a developing solution to develop the coloring composition layer. By developing, an unexposed area in the coloring composition layer is dissolved in the developing solution and therefore removed. The developing solution is preferably an aqueous solution of an alkaline compound such as potassium hydroxide, sodium hydrogen carbonate, sodium carbonate, or tetramethylammonium hydroxide. The concentration of the alkaline compound in the aqueous solution is preferably 0.01 to 10 mass%, and more preferably 0.03 to 5 mass%. The developing solution may further contain a surfactant.

The developing method may be any of a paddle method, a dipping method, a spray method and the like. Furthermore, during the developing process, the substrate may be inclined at any angle.

After the developing process, the resultant colored pattern is preferably washed with water.

Furthermore, the resultant colored pattern is preferably subjected to post-baking. The temperature for the post-baking is preferably 150 to 250°C, and more preferably 160 to 235°C. The time for the post-baking is preferably 1 to 120 minutes, and more preferably 10 to 60 minutes.

The film thickness of the color filter after post-baking is, for example, preferably 3 µm or less, and more preferably 2.5 µm or less. The lower limit on the film thickness of the color filter is not particularly set, but is usually 0.3 µm or more, and may be 0.5 µm or more.

In the cyan colored curable composition of the present invention, it is preferable that when a colored pattern or colored coating film having a film thickness of 0.8 µm is formed using the cyan colored curable composition, the transmittance at a wavelength of 520 nm is 75% or more. When the transmittance falls within the above range, the color characteristics as cyan are excellent. Incidentally, the transmittance at a wavelength of 520 nm is more preferably 77% or more, and still more preferably 80% or more. The upper limit is not particularly set, but is preferably 95% or less.

In addition, it is preferable that when a colored pattern or colored coating film having a film thickness of 0.8 µm is formed using the cyan colored curable composition, the transmittance at a wavelength of 400 nm is 50% or more. When the transmittance falls within the above range, the color filter can be provided with high color sensitivity. Incidentally, the transmittance at a wavelength of 400 nm is more preferably 53% or more, and still more preferably 56% or more. The upper limit is not particularly set, but is preferably 80% or less.

Further, when a colored pattern or colored coating film having a film thickness of 0.8 µm is formed using the cyan colored curable composition, the transmittance at a wavelength of 580 nm is preferably less than 30%, and more preferably less than 25%. When the transmittance falls within the above range, the color filter can be provided with high color separability. Incidentally, the transmittance at a wavelength of 580 nm is still more preferably 23% or less, and yet still more preferably 21% or less. The lower limit is not particularly set, but is preferably 5% or more, and more preferably 10% or more.

Incidentally, in the present invention, the distinction between a cyan color filter and a blue color filter can be made as follows. Taking the absorbance at the maximum absorption wavelength as 1.0, a color filter whose absorbance is 0.5 at an absorption wavelength of 540 nm or more and less than 585 nm is recognized as cyan, while a color filter whose absorbance is 0.5 at an absorption wavelength of 500 nm or more and less than 540 nm is recognized as blue.

When the cyan colored curable composition contains the compound (1) and the organic pigment (Al) as the colorant (A), the transmittance characteristics described above can be achieved.

According to the cyan colored curable composition of the present invention, a cyan color filter having high sensitivity and color separability can be produced. The color filter is useful as a color filter for use in a display device (e.g., a liquid crystal display device, an organic EL device, an electronic paper, etc.) and a solid-state image sensor, and is particularly useful for a solid-state image sensor.

The present application claims priority based on Japanese Patent Application No. 2019-036723 filed on February 28, 2019. All the contents described in Japanese Patent Application No. 2019-036723 filed on February 28, 2019 are incorporated herein by reference.

### EXAMPLES

Hereinafter, the present invention will be described in further detail with reference to examples. However, naturally, the present invention is not limited to the following examples. In the examples, unless otherwise noted, "part" means "part by mass", and "%" means "mass%".

In the following synthesis examples, compounds were identified by mass analysis (LC: Model 1200 manufactured by Agilent Technologies, Inc., MASS: Model LC/MSD manufactured by Agilent Technologies, Inc.) or elemental analysis (VARIO-EL; manufactured by Elementar Co., Ltd.).

### [Synthesis Example 1]

### <Synthesis of Compound Represented by Formula (1-24-1a)>

To a flask equipped with a cooling tube and a stirrer, 75 parts of 4-nitrophthalonitrile and 375 parts of N,N-dimethylacetamide were charged, and, while maintaining 20°C or lower with stirring, 68.9 parts of sodium carbonate was gradually added. Further, while maintaining 20°C or lower with stirring, 68.9 parts of methyl 3-mercaptopropionate was added dropwise. After the completion of dropwise addition, the mixture was stirred at room temperature for 3.5 hours. The reaction solution was filtered, and the filtrate was injected into 2,250 parts of IN hydrochloric acid. The precipitate was filtered off, thoroughly washed with ion exchange water, and dried at reduced pressure at 50°C to give 104.4 parts of a compound represented by formula (1-24-1a).

### <Synthesis of Compound Represented by Formula (1-24-1b)>

To a flask equipped with a cooling tube and a stirrer, 52.0 parts of the compound (1-24-1a) and 104.0 parts of N,N-dimethylformamide were charged, and, while maintaining 20°C or lower with stirring, 40.2 parts of 1,8-diazabicyclo[5.4.0]-7-undecene (DBU) was added dropwise. After the completion of dropwise addition, the mixture was stirred at room temperature for 2.5 hours. The reaction solution was injected into 208.0 parts of water, and concentrated hydrochloric acid was further added until the pH reached 2 or less. The precipitate was filtered off, thoroughly washed with ion exchange water, and dried at reduced pressure at 50°C to give 33.6 parts of a compound (1-24-1b).

### <Synthesis of Compound Represented by Formula (1-24-1c)>

To a flask equipped with a cooling tube and a stirrer, 33.0 parts of the compound (1-24-1b) and 396 parts of acetic acid were charged, and, with stirring at room temperature, 4.2 parts of sodium tungstate was added. Further, while maintaining 30°C or lower with stirring, 87.5 parts of a 30% aqueous hydrogen peroxide solution was added dropwise. After the completion of dropwise addition, the temperature was raised to 50°C, and the mixture was stirred for 2 hours. The reaction solution was cooled to room temperature. The reaction solution was then injected into a solution prepared by dissolving 60.7 parts of potassium acetate in 396 parts of methanol and stirred for 1 hour. The precipitate was filtered off, washed with methanol, and dried at reduced pressure at 50°C to give 35.0 parts of a compound represented by formula (1-24-1c).

### <Synthesis of Compound Represented by Formula (1-24-1d)>

To a flask equipped with a cooling tube and a stirrer, 5.0 parts of the compound (1-24-1c), 0.82 parts of cupric chloride, 0.40 parts of ammonium molybdate, and 19.1 parts of quinoline were charged. The flask was set in an oil bath previously set at 100°C, and the temperature was raised to 160°C with stirring. Stirring was further continued for 3 hours, then the mixture was cooled to 100°C, and 66.5 parts of methanol was added. The precipitate was filtered off, washed with methanol, and dried at reduced pressure at 50°C to give 2.0 parts of a compound represented by formula (1-24-1d).

### <Synthesis of Compound Represented by Formula (1-24-1)>

To a flask equipped with a cooling tube and a stirrer, 57.6 parts of anhydrous N,N-dimethylacetamide and 1.5 parts of anhydrous N,N-dimethylformamide were charged. The mixture was cooled to 0°C, 2.3 parts of thionyl chloride was added dropwise, and stirring was continued at 0°C for 1 hour. Further, 1.8 parts of the compound (1-24-1d) was added, and the mixture was stirred at room temperature for 30 minutes, at 50°C for 1.5 hours, and at 80°C for 4 hours. The mixture was cooled to 0°C, and a mixed solution of 2.8 parts of N,N-dimethyl-1,3-propanediamine and 4.2 parts of triethylamine was added dropwise. The mixture was stirred at room temperature for 15 minutes and at 80°C for 4 hours, and 506.9 parts of methanol was added. The precipitate was filtered off, thoroughly washed with methanol, and dried at reduced pressure at 50°C to give 1.6 parts of a compound represented by formula (1-24-1).

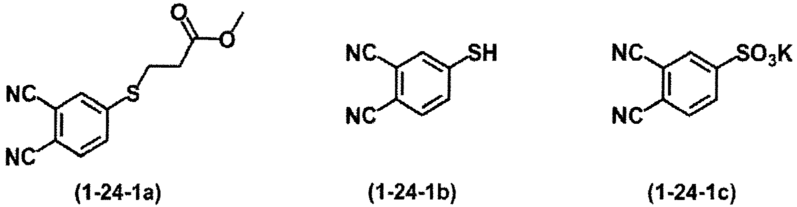

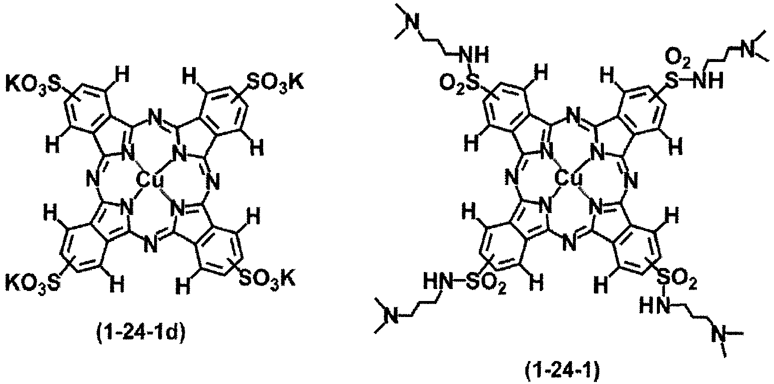

### [Synthesis Example 2]

An appropriate amount of nitrogen was passed through a flask equipped with a reflux condenser, a dropping funnel, and a stirrer to replace the atmosphere with nitrogen, and 141 parts of ethyl lactate and 178 parts of propylene glycol monomethyl ether acetate were added, followed by heating to 85°C with stirring. Next, a mixed solution of 38 parts of acrylic acid, 25 parts of a mixture of 3,4-epoxytricyclo[5.2.1.0^{2,6}]decan-8-yl acrylate and 3,4-epoxytricyclo[5.2.1.0^{2,6}]decan-9-yl acrylate (content ratio: 1:1), 137 parts of cyclohexyl maleimide, 50 parts of 2-hydroxyethyl methacrylate, and 338 parts of propylene glycol monomethyl ether acetate was added dropwise over 5 hours. Meanwhile, a mixed solution prepared by dissolving 5 parts of 2,2-azobisisobutyronitrile in 88 parts of propylene glycol monomethyl ether acetate was added dropwise over 6 hours. After the completion of dropwise addition, the mixture was kept at the same temperature for 4 hours and then cooled to room temperature to give a copolymer (resin (B-1)) solution having a solids content of 25.6%. The weight average molecular weight Mw of the generated copolymer was 8,000, the dispersity was 2.1, and the acid value on a solids basis was 111 mg-KOH/g.

The resin (B-1) has the following structural unit.

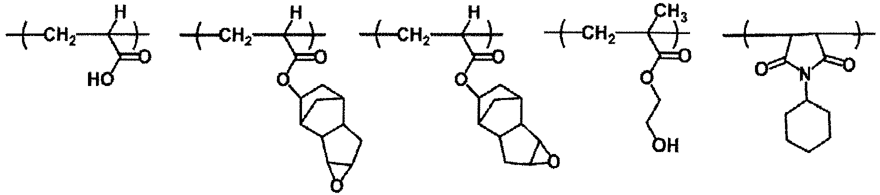

### [Production of Dispersion 1]

To a mixture of 12.1 parts of C.I. Pigment Blue 15:4, 3.6 parts of a dispersant (BYKLPN-6919 manufactured by BYK), 5.4 parts of the resin (B-1) (on a solids basis), and 78.9 parts of propylene glycol monomethyl ether acetate, 300 parts of 0.4-µm zirconia beads were added and shaken for 1 hour using a paint conditioner (manufactured by LAU). Subsequently, the zirconia beads were removed by filtration to give a dispersion 1.

### [Production of Dispersion 2]

A dispersion 2 was obtained in the same manner as in the production of the dispersion 1, except that C.I. Pigment Blue 15:4 was changed to C.I. Pigment Blue 15:6.

### [Production of Dispersion 3]

A dispersion 3 was obtained in the same manner as in the production of the dispersion 1, except that C.I. Pigment Blue 15:4 was changed to C.I. Pigment Blue 15:3.

### [Production of Dispersion 4]

A dispersion 4 was obtained in the same manner as in the production of the dispersion 1, except that C.I. Pigment Blue 15:4 was changed to C.I. Pigment Blue 15.

### [Production of Dispersion 5]

A dispersion 5 was obtained in the same manner as in the production of the dispersion 1, except that C.I. Pigment Blue 15:4 was changed to C.I. Pigment Green 58.

### [Examples 1 to 9, Comparative Examples 1 and 2]

### [Preparation of Colored Curable Composition]

Each colored curable composition was obtained by mixing the components shown in Table 1.

**TABLE 1**

| **Unit: parts** | **Example** | | | | | | | | | **Comparaive Example** | |
|---|---|---|---|---|---|---|---|---|---|---|---|
| | **1** | **2** | **3** | **4** | **5** | **6** | **7** | **8** | **9** | **1** | **2** |
| **Compound (A-1)** | **33** | **33** | | **33** | **33** | **43** | **41** | **37** | **29** | **45** | |
| **Compound (A-2)** | | | **33** | | | | | | | | |
| **Dispersion 1** | **116** | | | | | **19** | **38** | **76** | **157** | | **171** |
| **Dispersion 2** | | **116** | **116** | | | | | | | | |
| **Dispersion 3** | | | | **116** | | | | | | | |
| **Dispersion 4** | | | | | **116** | | | | | | |
| **Dispersion 5** | | | | | | | | | | | **256** |
| **Resin (B)** | **54** | **54** | **54** | **54** | **54** | **59** | **58** | **56** | **52** | **60** | **37** |
| **Polymerizable Compound (C)** | **40** | **40** | **40** | **40** | **40** | **40** | **40** | **40** | **40** | **40** | **40** |
| **Polymerization Initiator (D)** | **5** | **5** | **5** | **5** | **5** | **5** | **5** | **5** | **5** | **5** | **5** |
| **Solvent (E-1)** | **429** | **429** | **429** | **429** | **429** | **420** | **421** | **425** | **433** | **85** | **22** |
| **Solvent (E-2)** | **88** | **88** | **88** | **88** | **88** | **86** | **86** | **87** | **90** | **348** | |
| **Solvent (E-3)** | **275** | **275** | **275** | **275** | **275** | **336** | **324** | **300** | **250** | **418** | **617** |

The components in Table 1 are as follows.

Compound (A-1): Solvent Blue 67 (manufactured by BASF; compound represented by formula (1-11-2)) 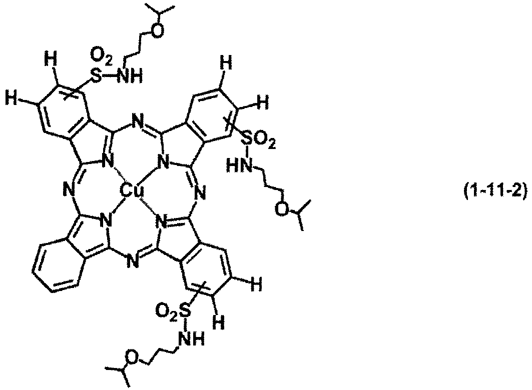
Compound (A-2): Compound represented by formula (1-24-1)
Resin (B): Resin (B-1) (on a solids basis)
Polymerizable Compound (C): Dipentaerythritol polyacrylate ("A9550" manufactured by Shin-Nakamura Chemical Co., Ltd., on a solids basis)
Polymerization Initiator (D): N-Benzoyloxy-1-(4-phenylsulfanylphenyl)octan-1-one-2-imine (IRGACURE (registered trademark) OXE01; manufactured by BASF)
Solvent (E-1): Ethyl lactate
Solvent (E-2): Diacetone alcohol
Solvent (E-3): Propylene glycol monomethyl ether acetate

### [Production of Colored Coating Film]

Onto a 5-cm square glass substrate (Eagle 2000; manufactured by Corning), a colored curable composition was applied by a spin coating method to a post-baked film thickness of 0.8 µm, and then pre-baked at 100°C for 3 minutes to form a colored composition layer. After being allowed to cool, the colored composition layer was irradiated with light using an exposure machine (TME-150RSK; manufactured by Topcon Corporation) in ambient atmosphere at an exposure dose of 500 mJ/cm² (365 nm standard). Subsequently, the layer was post-baked in an oven at 230°C for 20 minutes to give a colored coating film.

### [Transmittance Evaluation]

The colored coating film on the glass substrate obtained was spectroscopically measured using a colorimeter (OSP-SP-200; manufactured by Olympus Corporation), and the transmittances at wavelengths of 400 nm, 520 nm, and 580 nm were compared. The results are shown in Table 2. In the case where the transmittance at a wavelength of 520 nm was 75% or more, the cyan color characteristics were rated as excellent (o), while in the case of outside the above range, the cyan color characteristics were rated as poor (×). In addition, in the case where the transmittance at a wavelength of 400 nm was 50% or more, the color sensitivity was rated as excellent (o), while in the case of outside the above range, the color sensitivity was rated as poor (×). Further, in the case where the transmittance at a wavelength of 580 nm was less than 25%, the color separability was rated as excellent (o), in the case of 25% or more and less than 30%, the color separability was rated as fair (Δ), and in the case of 30% or more, the color separability was rated as poor (x). Incidentally, taking the absorbance at the maximum absorption wavelength of each colored coating film as 1.0, the absorption wavelength at which the absorbance is 0.5 (hereinafter referred to as absorption wavelength (H)) is shown in Table 2. In all the colored coating films obtained in Examples 1 to 9 and Comparative Examples 1 and 2, the absorption wavelength (H) was within a range of 540 nm or more and less than 585 nm.

**TABLE 2**

| | **Example** | | | | | | | | | **Comparaive Example** | |
|---|---|---|---|---|---|---|---|---|---|---|---|
| | **1** | **2** | **3** | **4** | **5** | 6 | **7** | **8** | **9** | **1** | **2** |
| **Film thickness (µm)** | **0.8** | **0.8** | **0.8** | **0.8** | **0.8** | **0.8** | **0.8** | **0.8** | **0.8** | **0.8** | **0.8** |
| **Absorption wavelength (H) (nm)** | **560** | **555** | **550** | **560** | **550** | **565** | **565** | **560** | **560** | **560** | **555** |
| **Transmittance at wavelength of 400nm (%)** | **60** | **58** | **71** | **56** | **56** | **56** | **56** | **57** | **59** | **55** | **40** |
| **Transmittance at wavelength of 520nm (%)** | **81** | **85** | **81** | **85** | **81** | **88** | **87** | **86** | **84** | **88** | **83** |
| **Transmittance at wavelength of 580nm (%)** | **20** | **17** | **15** | **18** | **17** | **29** | **26** | **21** | **14** | **32** | **28** |
| **Cyan color characteristic** | O | O | O | O | O | O | O | O | O | O | O |
| **Color sensitivity** | O | O | O | O | O | O | O | O | O | O | × |
| **Color separability** | O | O | O | O | O | △ | △ | O | O | × | × |

## Claims

1. A cyan colored curable composition comprising a colorant, a resin, a polymerizable compound, and a polymerization initiator,
the colorant comprising a compound represented by formula (1) and an organic pigment: 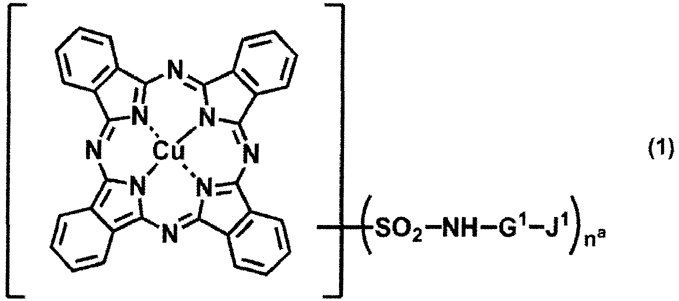
wherein
G¹ represents a C₂₋₂₀ alkanediyl group, wherein -CH₂- contained in the alkanediyl group is optionally substituted with -O-,
J¹ represents a hydrogen atom, -NR^{a}R^{b}, or -NR^{a}R^{b}H⁺Q⁻,
R^{a} and R^{b} each independently represent a hydrogen atom or a C₁₋₈ alkyl group, and when formula (1) has a plurality of R^{a}s, the R^{a}s may be the same or different from each other, and when formula (1) has a plurality of R^{b}s, the R^{b}s may be the same or different from each other,
Q⁻ represents a halide ion, BF₄⁻, PF₆⁻, ClO₄⁻, X-CO₂⁻, or X-SO₃⁻,
X represents a monovalent organic group,
in a case where formula (1) has a plurality of Q⁻s, the Q⁻s may be the same or different from each other, and
n^{a} represents an integer of 1 to 4.

2. The cyan colored curable composition according to claim 1, wherein the organic pigment is a blue organic pigment.

3. The cyan colored curable composition according to claim 1 or 2, wherein the organic pigment is a phthalocyanine pigment.

4. The cyan colored curable composition according to any one of claims 1 to 3, wherein the organic pigment is at least one selected from the group consisting of C.I. Pigment Blue 15, C.I. Pigment Blue 15:3, C.I. Pigment Blue 15:4, and C.I. Pigment Blue 15:6.

5. The cyan colored curable composition according to any one of claims 1 to 4, further comprising a solvent.

6. A color filter formed from the cyan colored curable composition according to any one of claims 1 to 5.

7. A solid-state image sensor comprising the color filter according to claim 6.
